# EUROPEAN PATENT APPLICATION

(11) **EP 2 169 092 A2**
(43) Date of publication of application: **31.03.2010**
(21) Application number: 10150458.7
(22) Date of filing: 16.12.2005
(51) Int. Cl.: C23C 14/16, C23C 14/58

(54) **Substrate with antimicrobial properties**

(30) Priority: 16.12.2004 EP 04106648; 10.03.2005 EP 05101882
(62) Divisional of application: 05826433.4
(71) Applicant: AGC Flat Glass Europe SA, 1170 Bruxelles (BE)
(72) Inventor: Jacobs, Nadia, 6040, JUMET (BE); Hevesi, Kadosa, 6040, JUMET (BE); Hecq, André, 6040, JUMET (BE); Poels, Jean-Pierre, 6040, JUMET (BE); Ego, Christophe, 6040, JUMET (BE); Pilloy, Georges, 6040, JUMET (BE)
(74) Representative: Vandeberg, Marie-Paule L.G.

(57) **Abstract**

A process for the production of a substrate having antimicrobial properties is described. It comprises a step consisting of the deposition of a metal non-gelling layer comprising an inorganic antimicrobial agent, starting from a precursor, in metal, colloid, chelate or ion form on at least one of the surfaces of the metallic substrate; and a step consisting of the diffusion of the agent into said at least one surface of the substrate by thermal treatment. Alternatively, the substrate may be coated with an underlayer or a topcoat and the diffusion occurs either in the underlayer or in the topcoat.
Metallic substrates having antimicrobial properties are also described. In particular, a substrate exhibiting a bactericidal activity measured in accordance with standard JIS Z 2801 of higher than log 2.

## Description

The present invention relates to a Substrate, in particular metallic substrate, wherein at least one of its surfaces has antimicrobial, in particular antibacterial or antifungal, properties. The present invention also relates to a process for the production of such a substrate.

In the field of ceramic substrates, EP 653 161, for example, describes the possibility of covering these with a glaze composed of silver to provide them with antibacterial properties.

In the field of glass-type substrates, sol-gel type processes are known to provide an antimicrobial surface. These processes require a hardening stage of the sol-gel layer, which involves elevated temperatures in the order of 500°-600°C (sintering temperature). Processes are also known that require the substrate to be dipped in a composition comprising a silver salt. In this case, a silver layer is not deposited, but an ion exchange takes place in the solution at an elevated temperature.

A process for producing a glass substrate having antimicrobial properties is also known from EP 1449816. This process requires both a drying stage between 20° and 105°C and a thermal treatment at 600°-650°C. This thermal treatment has some disadvantages particularly with respect to cost and uniformity of the product. Moreover, it renders the process very poorly reproducible, since it has been found that at these temperatures the diffusion of the silver is very rapid and a slight variation in the duration of the thermal treatment results in a significant variation in the depth of diffusion of the silver, and therefore this causes variation in the antibacterial properties of the substrate. It may also be noted that such a thermal treatment causes an undesirable yellow colouration of a soda-lime glass substrate. Furthermore, with this process, after having been treated, the product may no more be cut into particular size because of the necessary tempering process.

Therefore, there is a need to provide a metallic substrate, with antimicrobial properties, which is easy to use and inexpensive to produce.

According to one embodiment, the present invention relates to a process for the production of a substrate (in particular metallic substrate) having antimicrobial properties, characterised in that it comprises the following steps:
(i) deposition of a non-gelling layer comprising an inorganic antimicrobial agent in metal, colloid, chelate or ion form on at least one of the surfaces of the glass substrate;
(ii) diffusion of the agent into or under said at least one surface of the substrate by thermal treatment at a temperature comprised between 200 and 350°C for a period varying from 10 to 30 minutes.

According to another embodiment, the process is characterised in that it comprises the following sequential steps:
(i) deposition of a metal non-gelling layer comprising an inorganic antimicrobial agent, obtained at the outset from a precursor, in metal, colloid, chelate or ion form, on at least one of the surfaces of the substrate;
(ii) deposition of a topcoat;
(iii) diffusion of the agent in said topcoat by thermal treatment at a temperature comprised between 200 and 750°C.

During the thermal treatment, the antimicrobial agent can diffused under the surface, toward the centre of the substrate, if no coating is applied or in an undercoat, or in a topcoat, in case those coating are applied on the substrate.

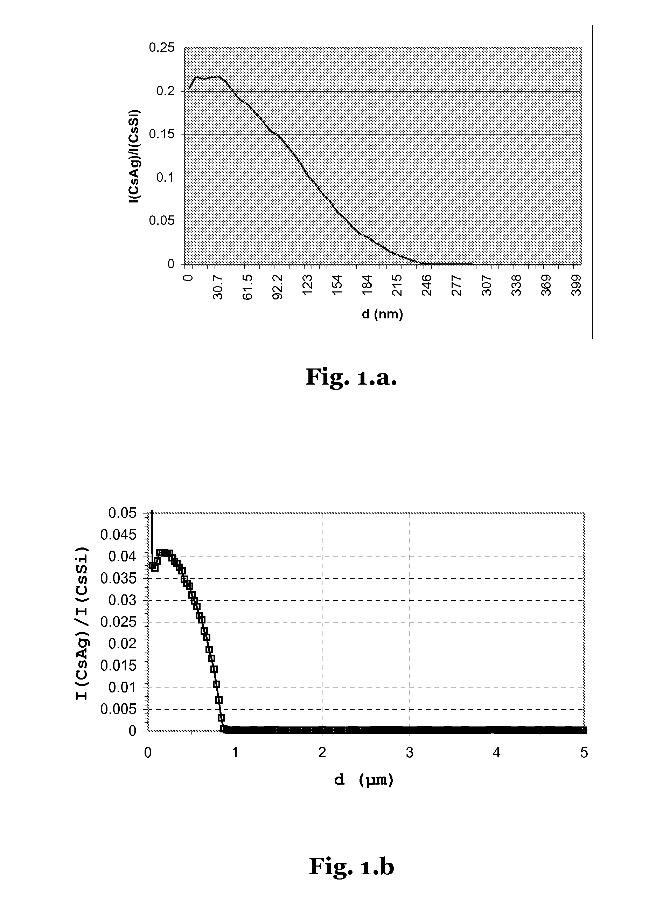

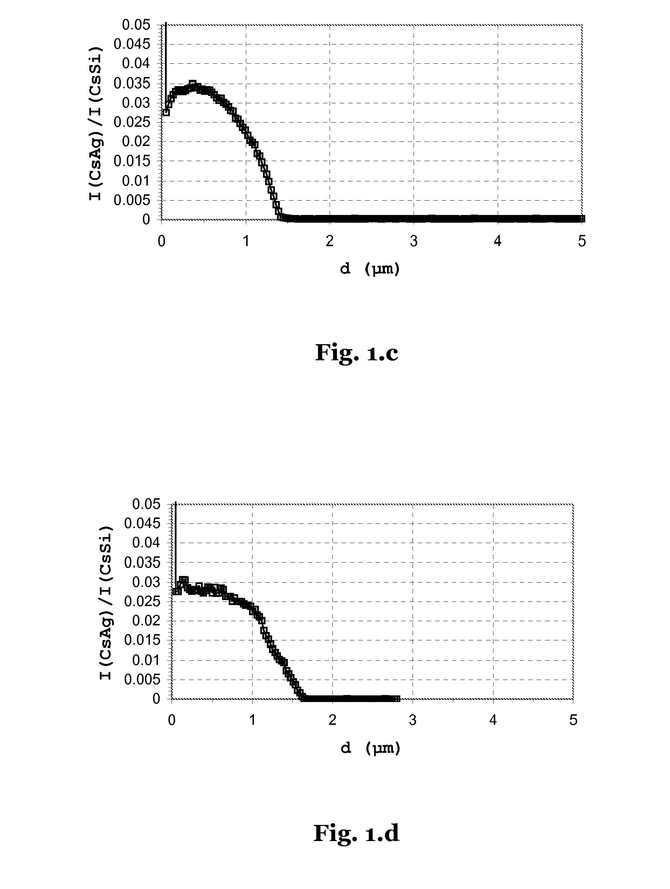

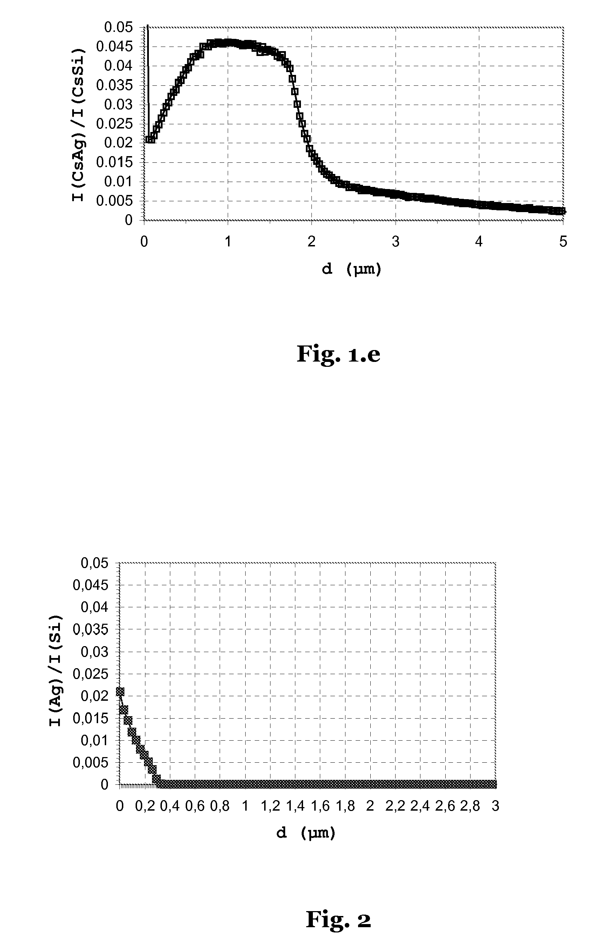

If an undercoat is applied, it can advantageously comprise a first layer, having the functions of blocking or slowing down the migration of the antimicrobial agent and a second layer serving as a reservoir for the antimicrobial agents. Those functions can be ascertained on a product made according to the invention by comparing the antimicrobial effect of similar products with and without undercoating and/or by analysing diffusion profiles (see fig 1 and 2).

Each layer of the undercoat may in particular have a thickness comprised between 5 and 1000 nm, preferably between 8 and 800 nm, most preferably between 10 and 600 nm.

The substrate may have a surface area of greater than 0.8 m to 0.8 m; it may be adapted to be cut to a finished size by a subsequent cutting operation.

The antimicrobial agent can be selected from various inorganic agents known for their antimicrobial properties, in particular silver, copper and zinc. Advantageously, the antimicrobial agent is in metallic form.

The process according to the invention advantageously comprises an additional step (iii), which consists of eliminating any excess antimicrobial agent remaining on the surface, i.e. that has not diffused during the thermal treatment step (ii). This elimination can be achieved by washing. In particular, solutions based on HNO₃, FeCl₃ or Fe(NO₃)₃ are suitable for such a washing process. This washing can prevent any antimicrobial agents from remaining on the surface in metallic form in such a quantity that they could cause the treated surface to become too reflective. For some applications, it is preferred that the substrate treated according to the invention does not exhibit any significant increase in light reflection (LR), or any significant reduction in light transmission (LT) in relation to the untreated substrate.

It has been found that with the process according to the invention, a very low quantity of antimicrobial agent can be deposited on said at least one surface of the substrate. In some cases, a quantity of more than 5 mg/m², preferably more than 20 mg/m² and particularly preferred more than 35 mg/m² of surface to be treated can be appropriate. However, the use of much higher concentrations (800 or 900 mg/m2) does not impede the result, instead such concentrations have proved to be simply unnecessary and can require excess to be eliminated on a much more significant scale.

Various methods known per se can be suitable for depositing the layer comprising the antimicrobial agent. In particular, deposition is possible by sputtering or by a method similar to the method used for the production of mirrors, which comprises spraying of a salt of an antimicrobial agent such as AgNO₃ and precipitation by reduction of the antimicrobial agent in metal form.

The invention also relates to metallic substrates comprising antimicrobial agents present at or diffused into or under at least one of its exposed surface at an atomic % preferably greater than 1% more, preferably greater than 1.5%, most preferably greater than 2%.

The substrate according to the invention has an antibacterial effect on a large number of bacteria, whether gram positive or gram negative bacteria, in particular on at least one of the following bacteria: Escherichia coli, Staphylococcus aureus, Pseudomonas aeruginosa, Enterococcus hirae. The antibacterial effect measured in accordance with the standard JIS Z 2801 is in particular, at least on any one of these bacteria, higher than log 1, preferably higher than log 2 and particularly preferred higher than log 2.5. The substrate will be considered bactericidal according to the standard JIS Z 2801 if it has an effect higher than log 2. However, the invention also relates to substrates that have a lesser effect (for example a bacteriostatic effect, which means that the bacteria are not necessarily killed but can not developed anymore).

The substrate according to the invention advantageously has an antifungal (fungicidal or fungistatic) effect on any one fungus, in particular *Candida albicans or Aspergillus niger.*

It can be considered that antimicrobial properties may be obtained without changing very much the initial colour of the substrate. The change of coloration is generally expressed with the colorimetric index by Delta E* ; DeltaE* = [ (l*₁ - l*₂)² + (a*₁ - a*₂)² + (b*₁ - b*₂)²]^{1/2}. A DeltaE* lower than 3, preferably lower than 2 may be obtained for an antimicrobial substrate according to the invention.

The substrate according to the invention preferably has in particular an antimicrobial effect after any one of the following accelerated ageing tests: wet spray test (test over 20 days in a chamber with a humidity of more than 95% at 40°C), after 500 hours of UV irradiation (4 340A ATLAS lamps, chamber at 60°C), after 24 hours immersed in a solution of H₂SO₄ (0.1 N), after 24 hours immersed in a solution of NaOH (0.1 N).

Preferred or alternative embodiments of the present invention are described in dependant claims.

The present invention shall be described in more detail below, in a non-restrictive manner, with reference to the attached drawings:
Figures 1a to 1h show diffusion profiles of silver into the surface of the substrate for samples obtained using the procedure of Example 1 (deposition of the silver layer by spraying);
Figure 2 shows a diffusion profile of silver into the surface of the substrate for a sample obtained using the procedure of Example 2 (deposition by precipitation of a silver layer by reduction of the corresponding salt).

### EXAMPLE 1 (parent invention):

### Production of antimicrobial samples

Samples of clear soda-lime glass were coated with a silver layer using the vacuum deposition method, also referred to as magnetron sputtering, in a manner known per se using a silver metal target in an atmosphere of argon. The quantity of silver deposited was 40 mg/m² of surface treated for sample 1.a (4 mm thick glass) and 100 mg/m² of surface treated for samples 1.b to 1.e (2 mm thick glass).

To cause the silver to diffuse into the surface, the samples were then subjected to a thermal treatment in the conditions (duration and temperature) specified in Table 1.

The treated samples were then washed in acid to eliminate any excess silver remaining in the surface that had therefore not diffused during the thermal treatment. The aim is to eliminate any trace of silver on the surface (mainly metallic Ag) and thus obtain a clear glass without eliminating the silver that has lightly diffused into the surface. Solutions of HNO₃, FeCl₃ or Fe(NO₃)₃ are suitable for such a washing process.

Figures 1.a to 1.e show the quantity of silver diffused into the surface of the substrate as a function of the depth (d) in the substrate. The quantity of silver is estimated by measuring the I(CsAg) / I(CsSi) ratio obtained by dynamic SIMS. I(CsAg) is the peak intensity obtained for the CsAg⁺ ions and I(CsSi) is the peak intensity obtained for the CsSi⁺ ions after bombardment of the surface of the substrate by a Cs⁺ ion beam using a Cameca ims-4f apparatus (beam of 5.5 keV and angle of incidence of 42° to the normal of the substrate).

### Measurement of the antimicrobial effect

The bactericidal and fungicidal properties of some samples were analysed in accordance with standard JIS Z 2801. The results are collated in Table 1 below.

A log 1 level indicates that 90% of the bacteria inoculated onto the surface of the glass were killed in 24 hours in the conditions of the standard; log 2 indicates that 99% of the bacteria were killed; log 3 indicates that 99.9% of the bacteria deposited were killed, etc.

**Table 1**

| **Examples** | **Temperature °C** | **Duration (minutes)** | **Diffusion Profile** | **I(Cs/Ag) / I(Cs/Si)** | **Bacterium or fungus tested** | **Anti-microbial effect** |
|---|---|---|---|---|---|---|
| 1.a | 250 | 15 | Fig. 1.a | 0.200 | E.coli | > log 4 |
| 1.b | 250 | 30 | Fig. 1.b | 0.037 | E.coli | > log 4 |
| | | | | | E.coli | log 3.6 |
| | | | | | S.aureus | log 3.4 |
| 1.c | 300 | 15 | Fig. 1.c | 0.027 | P.aeruginosa | log 4.1 |
| | | | | | E.hirae | log 1.0 |
| | | | | | C.albicans | log 1.2 |
| 1.d | 350 | 15 | Fig. 1.d | 0.027 | | |
| 1.e | 400 | 15 | Fig. 1.e | 0.021 | E.coli | log 1.6 |

Sample 1.a has an appearance that is neutral in reflection. The colorimetric indexes are a* = -0.2 and b* = -0.9 and the purity is 1.9%. Sample 1.c also has an appearance that is neutral in reflection. The colorimetric indexes are a* = -0.2 and b* = -0.7 and the purity is 1.5% (measured with illuminant D, angle of 10°).

Accelerated ageing tests were conducted on sample 1.c, which showed that the antimicrobial effect survived. An antibacterial effect with respect to E.coli of higher than or equal to log 4 was measured after the following artificial ageing tests:
- wet spray (test for 20 days in a chamber with a humidity of more than 95% and at 40°C);
- after 500 hours of UV irradiation (4 340A ATLAS lamps, chamber at 60°C),
- after 24 hours immersed in an H₂SO₄ solution (0.1 N),
- after 24 hours immersed in an NaOH solution (0.1 N).

### Example 2 (parent invention)

Samples of clear soda-lime glass 4 mm thick were coated with a silver layer by chemical deposition using a method similar to that used to produce mirrors.

The samples were firstly subjected to a step of sensitisation using tin chloride solution. An aqueous solution of AgNO₃ was then sprayed onto the surface of the glass at a flow rate of 200 ml/min along with a reducing agent to reduce the silver salt into metallic silver. The excess was then rinsed off. Quantities of 100 to 800 mg of Ag/m² were deposited onto one face of the glass substrates.

To cause the silver to diffuse into the surface, the different samples were then subjected to different thermal treatments for a period of 10 to 30 minutes at temperatures varying from 250° to 350°C (see Table 2).

The treated samples were then washed in acid to eliminate the excess silver remaining in the surface as in Example 1.

The diffusion profile of sample 2.d is shown in Figure 2.

The antimicrobial effect was analysed using the same method as in Example 1 and the results are collated in Table 2 below.

**Table 2:**

| **Examples** | **Concentration of Ag deposited (mg/m²)** | **Temperature and duration of thermal treatment** | **I(CsAg)/ I(CsSi)** | **Bacterium** | **Anti-microbial effect** |
|---|---|---|---|---|---|
| 2.a | 100 | 250°C, 15 min | 0.15 | *E.coli* | > log 4.8 |
| 2.b | 100 | 300°C, 15 min | 0.14 | *E.coli* | > log 4.8 |
| 2.c | 100 | 350°C, 10 min | 0.075 | *E.coli* | > log 4.8 |
| 2.d | 250 | 300°C, 15 min | 0.021 | *E.coli* | > log 3.6 |
| 2.e | 300 | 250°C, 15 min | 0.22 | *E.coli* | log 4.8 |
| 2.f | 300 | 300°C, 15 min | 0.23 | *E.coli* | log 4.8 |
| 2.g | 300 | 350°C, 10 min | 0.13 | *E.coli* | > log 4.8 |

### Example 4 (parent invention)

Samples of clear soda-lime glass were coated with one or two layers of different metal oxides or oxycarbides with a thickness varying between 13 and 500 nm, using pyrolytic deposition. The nature and thicknesses of the layers are collated in Table 3 below.

A layer of silver (100 to 500 mg/m²) was deposited on the last layer of the substrate and a tempering thermal treatment was applied (temperature: 680°C, duration 6 minutes).

**Table 3:**

| **Substrate** | **Concentration of Ag deposited (mg/m²)** | **Bacterium** | **Antibacterial effect (log)** |
|---|---|---|---|
| Glass / TiO₂ (45 nm) | 100 | E.coli | 1.6 |
| | 300 | E.coli | 2.2 |
| Glass / SiOxCy (70 nm) | 100 | E.coli | 4.8 |
| | 500 | E.coli | 4.8 |
| Glass / SnO₂:F (500 nm) | 100 | E.coli | 1.1 |
| Glass / SiOxCy (75 nm) / SnO₂:F (300 nm) | 100 | E.coli | > 4.8 |
| | 500 | E.coli | > 4.8 |
| Glass / SiO₂ (25 nm) / TiO₂ (13 nm) | 100 | E.coli | 3.5 |
| | 500 | E.coli | 4.3 |

The bactericidal properties of the samples were analysed in accordance with standard JIS Z 2801. The results are collated in Table 3 above.

It is noted that, as a result of the layer or layers firstly deposited on the substrate, the antimicrobial effect is retained despite the thermal treatment at high temperature. Therefore, a product is obtained that has both the advantages of a tempered glass and of an antimicrobial glass.

The presence of the coating layer may reduce the variability of the antimicrobial effect of the finished product to variations in the heat treatment process. In addition, it may provide a surface or material that is better adapted to contain the antimicrobial agent that the surface of the substrate.

For simplicity, it is also possible to conduct the tempering step at a later stage. To be able to preserve the substrates prior to tempering, it is thus recommended that a first thermal treatment is conducted at low temperature and for a short period (e.g. from 250° to 400°C for 5 to 30 minutes) in order to cause the antimicrobial agent to diffuse into the layer or layers. The result is a glass sheet that can be cut to a desired size and then tempered in a subsequent process.

### Example 5 (parent invention)

A sample of clear soda-lime glass pyrolitically coated with a first layer of SiOx (75 nm) and a second layer of Sn02 doped with Fluorine (320nm) was used. A silver layer of 100 mg/m2 was deposited by the vacuum deposition method as in example 1 using a silver target in an argon atmosphere.

The coated samples were subjected to a tempering process (670°C during 10 minutes).

The bactericidal properties of the sample was analysed in accordance with standard JIS Z 2801. A log 2.58 was obtained. This indicates that good bactericide properties were obtained simultaneously with tempering characteristics.

### Example 6 (parent invention)

A sample of clear soda-lime glass coated by vacuum sputtering with the following stack of layers : Glass / ZnSnOx (10 nm) / NiCr (80-20) (1.8 nm) / Ag (2.2 nm or about 20 mg/m2) / ZnSnOx (10 nm).

The coated sample was subjected to a tempering process (670°C during 10 minutes).

The bactericidal properties of the sample were analysed in accordance with standard JIS Z 2801. A log 2.63 was obtained. This indicates that good bactericide properties were obtained simultaneously with tempering characteristics. This suggests that a certain amount of silver migrated during the tempering step in the topcoat and that the NiCr layer played a barrier function for the migration of Ag toward the substrate.

### Example 7

Samples of steel were coated with a silver layer using the vacuum deposition method as in example 1. A first sample was a galvanized steel of the commercial type "ST37" with a thickness of 1.5 mm. The second one was a sample of steel laminated under cold condition and without oil of a thickness of 0.2 mm.

After having been washed properly, the samples were coated using a silver metal target in an atmosphere of argon. The quantity of silver deposited was 100 mg/m2 of the surface treated.

The samples were subjected to a thermal diffusion process at 320°C during 10 min.

The bactericidal properties of both samples were analysed as previously and a log 3.53 was obtained for both samples.

When the substrate is a metal, particularly a sheet metal, and particularly steel, a coating layer may be provided at the surface to receive or contain the antimicrobial agent. Coating layers selected from one or more of a titanium oxide, a titanium nitride and a zirconium oxide may be particularly suitable.

When the substrate is a flat glass substrate, the use of coating layers selected from one or more of silicon oxide, a silicon nitride, a tin oxide, a zinc oxide, a zirconium oxide, a titanium oxide, a titanium nitride and an aluminium nitride may be used.

A double coating layer may be used, for example, substrate / zirconium oxide / titanium oxide.

## Claims

1. Process for the production of a metallic substrate having antimicrobial properties, **characterised in that** it comprises the following steps:
(i) deposition of a metal non-gelling layer comprising an inorganic antimicrobial agent, obtained at the outset from a precursor, in metal, colloid, chelate or ion form, on at least one of the exposed surfaces of the substrate;
(ii) diffusion of the agent under said at least one exposed surface of the substrate by thermal treatment at a temperature in the range of between 200° and 350°C for a period varying from 10 to 30 minutes.

2. Process according to claim 1, **characterised in that** the temperature of the thermal treatment is higher than 220°C and particularly preferred higher than 240°C.

3. Process according to any one of the preceding claims, **characterised in that** the precursor used in step (i) is in a metallic or ionic form, in particular in ionic form and dissolved in an aqueous solution.

4. Process according to claim 3, **characterised in that** the non-gelling layer comprising the antimicrobial agent is deposited either by vacuum sputtering or by a method involving the precipitation of metal antimicrobial agents by reduction of a corresponding salt.

5. Process according to any one of the preceding claims, **characterised in that** the antimicrobial agent is selected from silver, copper and zinc.

6. Process according to any one of the preceding claims, **characterised in that** the quantity of antimicrobial agents deposited on said at least one surface of the substrate is more than 5 mg/m², preferably more than 10 mg/m², and particularly preferred more than 20 mg/m².

7. Process according to any one of the preceding claims, **characterised in that** the substrate is coated with an undercoating before the deposition of step (i), and **in that** the diffusion of step (ii) occurs mainly within the coating.

8. Process according to the preceding claim, **characterised in that** the undercoating comprises a first underlayer, having the function of blocking or slowing down the migration of the antimicrobial agent, and a second underlayer, serving as a reservoir for the antimicrobial agents.

9. Process according to the preceding claim, **characterised in that** the blocking underlayer is chosen amongst pyrolitic and sputtered layers, in particular layers comprising metal oxide, metal or metal alloy compound, such as Pd, Ni-Cr, TiOx, NiCrOx, Nb, Ta, Al, Zr or ZnAl, or mixture thereof.

10. Process according to claim 7, **characterised in that** the undercoat comprises a first layer based on ZrO2 and a second layer based on Ti02, in particular in the anatase crystallised form.

11. Process for the production of a metallic substrate having antimicrobial properties, **characterised in that** it comprises the following steps:
a. deposition of a metal non-gelling layer comprising an inorganic antimicrobial agent, obtained at the outset from a precursor, in metal, colloid, chelate or ion form, on at least one of the surfaces of the substrate;
b. deposition of a top coat
c. diffusion of the agent in said topcoat by thermal treatment at a temperature comprised between 200 and 750°C for a period in the range of between 2 minutes and 2 hours.

12. Substrate obtained by a process according to anyone of claims 1 to 11 comprising antimicrobial agents diffused into at least one of its exposed surfaces, **characterised in that** the total quantity of antimicrobial agents it comprises is more than 0.1 mg/m², preferably more than 1 mg/m² and particularly preferred more than 10 mg/m² of antimicrobial surface.

13. Substrate according to the preceding claim, **characterised in that** on at least one of the following bacteria: E. *coli, S. aureus, P. aeruginosa* (measured in accordance with the standard JIS Z 2801), it has a bactericidal effect higher than log 1, preferably higher than log 2 and particularly preferred higher than log 2.5.

14. Substrate according to any one of Claims 12 to 13, **characterised in that** it has an antimicrobial effect after any of the following accelerated ageing tests: wet spray (test for 20 days in a chamber with a humidity of more than 95% and at 40°C), 500 hours of UV irradiation (4 340A ATLAS lamps, chamber at 60°C), after 24 hours immersed in a solution of H₂SO₄ (0.1 N), after 24 hours immersed in a solution of NaOH (0.1 N).

15. Substrate according to any one of Claims 12 to 14, **characterised in that** the antimicrobial agent is selected from silver, copper and zinc.
